# FASCICULE DE BREVET EUROPEEN

(11) **EP 3 900 175 B1**
(45) Date de publication et mention de la délivrance du brevet: **19.07.2023**
(21) Numéro de dépôt: 19832956.7
(22) Date de dépôt: 20.12.2019
(51) Int. Cl.: H02P 3/22, H02P 11/06, H02P 25/03, H02P 29/024, H02P 9/02

(54) **SYSTEME DE COMMANDE D'UN CONVERTISSEUR DE TENSION**
SYSTEM ZUR STEUERUNG EINES SPANNUNGSWANDLERS
SYSTEM FOR CONTROLLING A VOLTAGE CONVERTER

(30) Priorité: 20.12.2018 FR 1873476
(43) Date de publication de la demande: 27.10.2021
(73) Titulaire: VALEO EQUIPEMENTS ELECTRIQUES MOTEUR, 94046 Créteil Cedex (FR)
(72) Inventeur: BERTRAND, Mathieu, 94046 CRETEIL CEDEX (FR); LECOCQ, Yann, 94046 CRETEIL CEDEX (FR); LAHBIL, Hicham, 94046 CRETEIL CEDEX (FR)
(74) Mandataire: Valeo Powertrain Systems
(86) Numéro de dépôt international: PCT/EP2019/086775
(87) Numéro de publication internationale: WO 2020/128029

(56) Documents cités:
- EP-A2- 3 002 865
- JP-A- 2015 084 624
- US-A1- 2008 304 189
- US-A1- 2010 036 555
- US-A1- 2014 021 893
- US-A1- 2015 280 624
- US-A1- 2017 237 381
- US-A1- 2017 305 274

## Description

La présente invention est relative aux systèmes électriques comprenant une machines électriques tournante pour véhicule automobile pilotée par un convertisseur de tension. Elle concerne plus précisément un système de commande d'un convertisseur de tension et un système électrique comprenant une machine électrique tournante et un tel système de commande.

Il est connu des convertisseurs de tension comprenant un système de commande et une pluralité de bras de commutation montés en parallèle, chaque bras comprenant un interrupteur de côté haut et un interrupteur de côté bas connectés l'un à l'autre en un point milieu, chaque point milieu étant destiné à être connecté à au moins une phase d'une machine électrique tournante. Le système de commande commande l'ouverture ou la fermeture de chaque interrupteur pour commander l'alimentation de la machine électrique. Les interrupteurs côté bas ou les interrupteurs côté haut sont des interrupteurs électroniques d'alimentation, par exemple de type transistor à effet de champ métal-oxyde, connu aussi sous l'acronyme MOSFET de l'anglais (*Métal Oxide Semiconductor Field Effect Transistor*). Les interrupteurs permettent d'alimenter des phases d'un stator, soit dans un mode moteur à partir d'une batterie alimentant électriquement un réseau de bord du véhicule, soit dans un mode alternateur pour alimenter le réseau de bord et recharger une batterie du véhicule. Dans le cas d'une machine électronique comprenant trois phases au stator, le convertisseur de tension comprend trois interrupteurs côtés bas reliés chacun à une des trois phases et à la masse et trois interrupteurs côté haut reliés chacun à une des trois phases et à une borne positive correspondant au réseau de bord du véhicule automobile.

Suite à une défaillance d'un équipement électrique du véhicule automobile relié au réseau de bord, il peut se produire une surtension sur le réseau de bord, c'est-à-dire l'apparition d'une tension sur le réseau de bord très supérieure à la tension nominale de ce réseau.

Par exemple une telle surtension peut se produite dans le cas d'un défaut de fonctionnement d'un interrupteur du convertisseur de tension qui reste à l'état ouvert ou qui reste à l'état fermé alors que le système de commande le commande respectivement à l'état fermé ou à l'état ouvert.

Une telle surtension peut endommager ou réduire la fiabilité non seulement de la machine électrique tournante ou du convertisseur de tension et de son système de commande mais aussi d'éventuelles appareils électriques connectés sur le réseau de bord.

Pour limiter ou arrêter la surtension, il est connu que le système de commande de la machine électrique comprenne des dispositifs de détection associés à chacun des interrupteurs. Un tel dispositif de détection permet de détecter et d'identifier un défaut de l'interrupteur auquel il est associé et de commander la fermeture et l'ouverture des autres interrupteurs en fonction du défaut identifié pour limiter ou arrêter la surtension.

Par exemple, dans le cas d'un interrupteur de côté haut qui reste dans un état fermé, le détecteur de défaut de cet interrupteur va détecter un défaut d'état resté fermé pour cet interrupteur et transmettre l'information de détection de ce défaut à un module de commande du système de commande qui va commander la fermeture des deux autres interrupteurs haut et mettre ainsi la machine électrique tournante en sécurité par la mise de l'ensemble des phases du stator au même potentiel (i.e. les phases sont en court-circuit).

Cependant, un tel système de commande doit comporter autant de détecteurs de défaut que d'interrupteurs, ce qui engendre un coût important et des difficultés de logement de ces détecteurs de défaut au sein du système de commande.

Les documents US 2017/237381 A1 et US2008304189 A1 décrivent un système de commande selon le préambule de la revendication 1.

### RÉSUMÉ DE L'INVENTION

L'invention a pour but de pallier au moins en partie à ces inconvénients.

A cet effet, l'invention concerne un système de commande selon la revendication 1.

Un tel système de commande permet de mettre le convertisseur de tension en sécurité dès lors que l'un des interrupteurs du convertisseur de tension est en court-circuit ou en circuit ouvert.

Par interrupteur de côté haut ou de côté bas, on entend un interrupteur électronique d'alimentation, par exemple de type transistor IGBT (de l'anglais Insulated Gate Bipolar Transistor) ou encore de type transistor à effet de champ métal-oxyde, connu aussi sous l'acronyme MOSFET de l'anglais (*Métal Oxide Semiconductor Field Effect Transistor*).

Ainsi, le système de commande protège le convertisseur de tension et la machine électrique tournante en fermant systématiquement tous les interrupteurs d'un même côté lorsqu'une surtension est détectée.

Un tel système, de par son côté systématique, ne nécessite pas la mise en place de moyens de détection et d'identification de défaut au niveau de chaque interrupteur. Il est donc moins volumineux et moins coûteux à mettre en oeuvre que les systèmes de commande antérieur.

Dans le cas où le système de commande commande à la fermeture tous les interrupteurs du groupe bas lorsque la tension mesurée est supérieure au premier seuil de sécurité, le convertisseur de tension est ainsi protégé lorsque l'un des interrupteurs de côté haut se met en circuit ouvert (l'interrupteur reste ouvert indépendamment de la commande qu'il reçoit) ou lorsque l'un des interrupteurs de côté bas se met en court-circuit (l'interrupteur reste fermé indépendamment de la commande qu'il reçoit).

Dans le cas où le système de commande commande à la fermeture tous les interrupteurs du groupe haut lorsque la tension mesurée est supérieure au premier seuil de sécurité, le convertisseur de tension est ainsi protégé lorsque l'un des interrupteurs de côté haut se met en court-circuit ou lorsque l'une des interrupteurs de côté bas se met en circuit ouvert.

Dans les deux cas, le convertisseur de tension est également protégé contre une surtension sur le réseau de bord créé par un équipement autre que le convertisseur de tension et/ou la machine électrique tournante.

Le dispositif selon l'invention peut également présenter une ou plusieurs des caractéristiques ci-dessous, considérées individuellement ou selon toutes les combinaisons techniquement possibles :

Selon un mode particulier de réalisation de l'invention, lorsque la tension mesurée est supérieure ou égale au premier seuil de sécurité, le module de commande est en outre conçu pour générer une commande d'ouverture des interrupteurs autres que ceux du premier groupe.

Cela permet d'éviter un court-circuit et d'abimer les interrupteurs du convertisseur de tension si l'un des interrupteurs du premier groupe est défaillant.

Selon un mode de réalisation, la tension mesurée est la tension de la source de tension continue. Par exemple, le module de mesure mesure la tension entre deux bornes du convertisseur de tension destinées à être connectées à la source de tension continue.

Selon un mode de réalisation, le premier seuil de sécurité est compris entre 1.10 et 1.25 fois la tension nominale de la source de tension continue d'alimentation du convertisseur, par exemple 1.2 fois la tension nominale de la source de tension continue. Par exemple, la tension nominale d'alimentation est égale à quarante-huit volts, et le premier seuil de sécurité est compris entre cinquante-trois volts et soixante volts.

Dans une variante de réalisation, le système de commande est paramétré pour ne pas commander la fermeture du deuxième groupe d'interrupteurs avant que le premier groupe d'interrupteurs n'ait été fermé.

Dans un mode particulier de réalisation de l'invention, le deuxième seuil de sécurité est compris entre 1.2 et 1.4 fois la tension nominale de la source de tension continue du convertisseur de tension, par exemple 1.33 fois la tension nominale de la source de tension continue.

Ainsi, on reste dans des valeurs de tension qui n'entraine pas de détérioration des composants du convertisseur de tension.

Dans un exemple de mise en oeuvre de ce mode de réalisation, la tension nominale de la source de tension continue est égale à quarante-huit volts et le deuxième seuil de sécurité est compris entre cinquante-huit et soixante-sept volts, par exemple soixante-quatre volts.

Dans un autre mode de réalisation de l'invention, le deuxième seuil de sécurité est égal à la somme du premier seuil de sécurité et au moins une tension comprise entre quatre volts et douze volts.

Dans un autre mode de réalisation de l'invention, le module de commande est en outre conçu pour générer une commande d'ouverture du premier groupe d'interrupteurs, lorsque la tension mesurée est supérieure ou égale au deuxième seuil de sécurité.

Cela permet d'éviter un court-circuit et d'abimer les interrupteurs du convertisseur de tension.

Dans un autre mode de réalisation de l'invention, les interrupteurs du premier groupe restent fermés, lorsque la tension mesurée est supérieure ou égale au deuxième seuil de sécurité. Cela permet de provoquer un court-circuit et d'utiliser soit le dispositif de protection contre les courts-circuits du véhicule, par exemple un fusible à fonte rapide, soit d'utiliser un des interrupteurs de chaque bras en les détériorant jusqu'à ce qu'ils soient tous ouvert.

Selon un mode de réalisation, le premier groupe d'interrupteurs est le groupe des interrupteurs de côté bas.

Selon un mode de réalisation, le premier groupe d'interrupteurs est le groupe des interrupteurs de côté haut.

L'invention concerne aussi une unité de commande pour commander les interrupteurs de côté haut et de côté bas, ladite unité de commande comprenant un système de commande décrit précédemment pouvant comprendre des caractéristiques d'un ou de plusieurs des modes de réalisations décrits précédemment.

L'invention concerne aussi un système électrique comprenant :
a. une première et une deuxième bornes d'alimentation destinée à être reliées à une source de tension continue, notamment à une batterie d'un véhicule automobile,
b. une machine électrique tournante comprenant un stator ayant au moins trois phases,
c. un convertisseur de tension pour alimenter la machine électrique tournante à partie de ladite source de tension continue, le convertisseur de tension comprenant :
   i. une pluralité de bras de commutation montés en parallèle, chaque bras comprenant un interrupteur de côté haut et un interrupteur de côté bas connectés l'un à l'autre en un point milieu, chaque point milieu étant connecté à au moins une phase de ladite machine électrique tournante, et
   ii. une unité de commande des interrupteurs de côté haut et de côté bas, ladite unité de commande comprenant un système de commande selon l'invention.

Le système électrique bénéficie des mêmes avantages, cités précédemment, que le système de commande.

Dans un mode de réalisation particulier du système électrique, l'unité de commande comprend en outre au moins un module de détection d'un défaut, par exemple un module de défaut de sens du courant de phase, et dans lequel lorsque le module de défaut détecte un défaut, l'unité de commande commande à la fermeture le premier groupe d'interrupteurs.

Dans un mode de réalisation particulier du système électrique, l'unité de commande comprend en outre :
- un contrôleur conçu pour commander les interrupteurs de côté haut et de côté bas,
- un module de contrôle machine destinée à recevoir d'une unité de commande électronique du véhicule une consigne pour soit mettre la machine électrique tournante en mode moteur, soit mettre la machine électrique tournante en mode alternateur, et agencée pour transformer cette consigne en une commande pour commander les interrupteurs de côté haut et de côté bas du convertisseur de tension,
- un module logique pour prioriser les commandes émises par le système de commande par rapport aux commandes émises par le module de contrôle machine, le module logique transmettant au contrôleur la commande des interrupteurs reçue soit par le module de contrôle machine soit par le système de commande.

L'utilisation d'un module logique permet d'assurer que le contrôleur reçoive une seule commande et ainsi d'éviter un disfonctionnement du système électrique.

L'invention vise également un procédé de commande d'un système de commande d'un convertisseur de tension selon l'invention, le convertisseur de tension étant connecté à une machine électrique tournante et à une source de tension continue, notamment à un réseau de bord d'un véhicule automobile, ledit procédé comprenant :
1. une étape de mesure par le module de mesure de la tension de la source de tension continue,
2. une étape de comparaison par le module de comparaison de la tension mesurée à un premier seuil de sécurité, et
3. une étape de génération par le module de commande d'une commande de fermeture d'un premier groupe d'interrupteurs choisi parmi le groupe haut ou le groupe bas, si la tension mesurée est supérieure au premier seuil de sécurité.

L'invention vise également un procédé de mise en sécurité d'un système électrique comprenant une machine électrique comprenant un stator ayant au moins trois phases, un convertisseur de tension pour alimenter la machine électrique tournante à partir d'une source de tension continue, le convertisseur de tension comprenant :
1. une pluralité de bras de commutation montés en parallèle, chaque bras comprenant un interrupteur de côté haut raccordé à une borne positive de la source de tension continue et un interrupteur de côté bas raccordé à la masse du véhicule ou à une borne négative de la source de tension continu, l'interrupteur bas et l'interrupteur haut de chaque bras étant connectés l'un à l'autre en un point milieu, chaque point milieu étant connecté à au moins une phase de ladite machine électrique tournante, et,
2. une unité de commande comprenant un système de commande selon l'invention avec ou sans les caractéristiques des différents modes de réalisation,

le procédé de mise en sécurité d'un système électrique comprend les étapes :
1. de mesure d'une tension de la source de tension continu,
2. de comparaison de la tension mesurée à un premier seuil de sécurité,
3. de fermeture d'un premier groupe d'interrupteur d'interrupteurs, choisi parmi le groupe des interrupteurs de côté haut ou le groupe des interrupteurs de côté bas, lorsque la tension d'alimentation mesurée est supérieure au premier seuil de sécurité.

### Brève description des dessins :

D'autres caractéristiques et avantages de l'invention ressortiront clairement de la description qui en est donnée ci-dessous, à titre indicatif et nullement limitatif, en référence aux figures annexées, parmi lesquelles :
La [Fig 1] représente un schéma de principe d'un système électrique comprenant une unité de commande comprenant un système de commande selon un exemple d'un premier mode de réalisation.
La [Fig 2] représente un schéma de principe d'une unité de commande comprenant un système de commande selon un exemple du premier mode de réalisation.
La [Fig 3] et la [Fig 4] représente un histogramme représentant la tension mesurée aux bornes d'une source de tension continu.

Pour plus de clarté, les éléments identiques ou similaires sont repérés par des signes de référence identiques sur l'ensemble des figures.

### Description détaillée

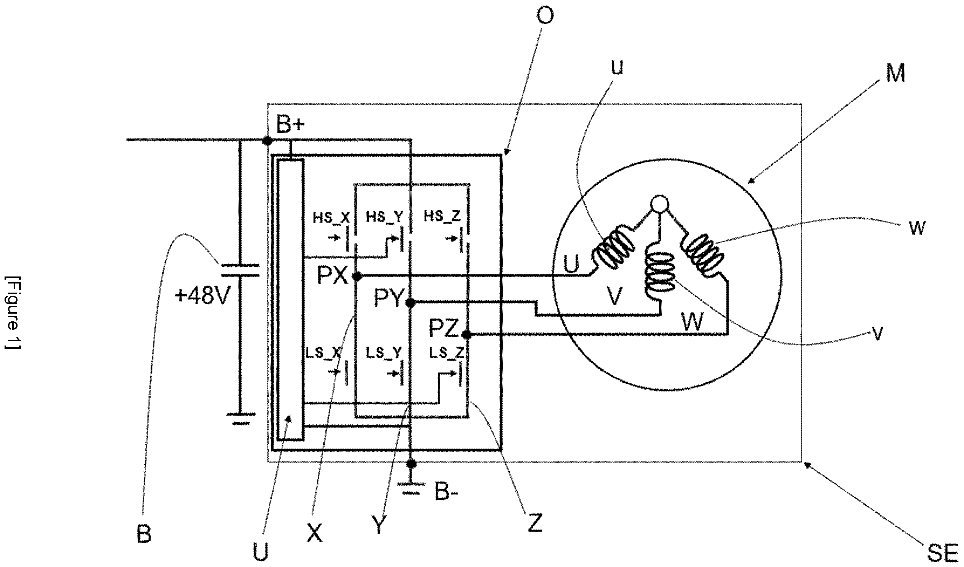

La [Fig.1] représente un schéma de principe d'un système électrique SE comprenant une première borne d'alimentation B+ et une deuxième borne d'alimentation B- reliées à une source d'alimentation continue B en l'occurrence dans cet exemple une source d'alimentation continue 48V, par exemple une batterie d'un véhicule automobile permettant d'alimenter d'autres équipements électriques non représentés du véhicule par le biais d'un réseau de bord. La source de tension continue peut comprendre la batterie d'un véhicule automobile et un bloc de condensateurs monté en parallèle avec la batterie du véhicule. Dans cet exemple, la deuxième borne B- est la masse du système électrique SE.

Le système électrique SE comprend une machine électrique tournante M comprenant un stator ayant au moins trois phases U, V, W et trois bobines u, v, w bobinées dans le stator. Dans cet exemple, les bobines u, v, w sont montées en étoile et comprennent chacune à leur sortie la phase correspondante U, V, W respectivement.

Le système électrique SE comprend en outre un convertisseur de tension O pour alimenter la machine électrique tournante M à partie de ladite source de tension continue B.

Le convertisseur de tension O comprend une pluralité de bras de commutation montés en parallèle entre les bornes B+ et B-. Le convertisseur de tension O comprend autant de bras que la machine électrique tournante M possède de phases. En l'occurrence, dans l'exemple décrit ici, le convertisseur de tension O comprend trois bras. Ainsi, le convertisseur de tension O comprend un premier bras X, un deuxième bras Y et un troisième bras Z.

Chaque bras X, Y, Z comprend un interrupteur de côté haut HS_X, HS_Y, HS_Z et un interrupteur de côté bas LS_X, LS_Y, LS_Z. Chaque interrupteur côté haut et côté bas d'un bras X, Y, Z sont connectés l'un à l'autre en un point milieu PX, PY, PZ. Les interrupteurs de côté haut forme un groupe d'interrupteur, dit groupe haut HS. De même, les interrupteurs de côté bas forme un groupe d'interrupteur, dit groupe bas BS.

Dans l'exemple décrit ici, chaque interrupteur de côté haut ou de côté bas est un transistor à effet de champ métal-oxyde comprenant chacun une diode de roue libre.

En l'occurrence, dans cet exemple, il y a donc sur le premier bras X un premier interrupteur de côté haut HS_X relié à un premier interrupteur de côté bas LS_X par un premier point milieu PX, sur le deuxième bras Y un deuxième interrupteur de côté haut HS_Y relié à un deuxième interrupteur de côté bas LS_Y par un deuxième point milieu PY et un troisième interrupteur de côté haut HS_Z, respectivement relié à un troisième interrupteur de côté bas LS_Z par un troisième point milieu PZ.

Chaque point milieu PX, PY, PZ est connecté à au moins une phase U, V, W de ladite machine électrique tournante M, soit en l'occurrence dans cet exemple le premier point milieu PX à la phase U, le deuxième point milieu PY à la phase V et le troisième point milieu Z à la phase W.

Le convertisseur de tension O comprend en outre une unité de commande U des interrupteurs de côté haut HS_X, HS_Y, HS_Z et de côté bas LS_X, LS_Y, LS_Z. Ladite unité de commande U comprend donc pour chaque interrupteur une sortie reliée à la commande de l'interrupteur correspondant. Pour ne pas surcharger la figure 1, uniquement la liaison entre une sortie de l'unité de commande U et la commande du troisième interrupteur de côté bas LS_Z et une autre sortie de l'unité de commande U et la commande du deuxième interrupteur de côté haut HS_Y ont été représentées.

L'unité de commande U contrôle les interrupteurs de chaque bras X, Y, Z en modulation de largeur d'impulsion MLI, plus connu sous l'acronyme anglais « PWM » de l'anglais « Pulse Width Modulation ».

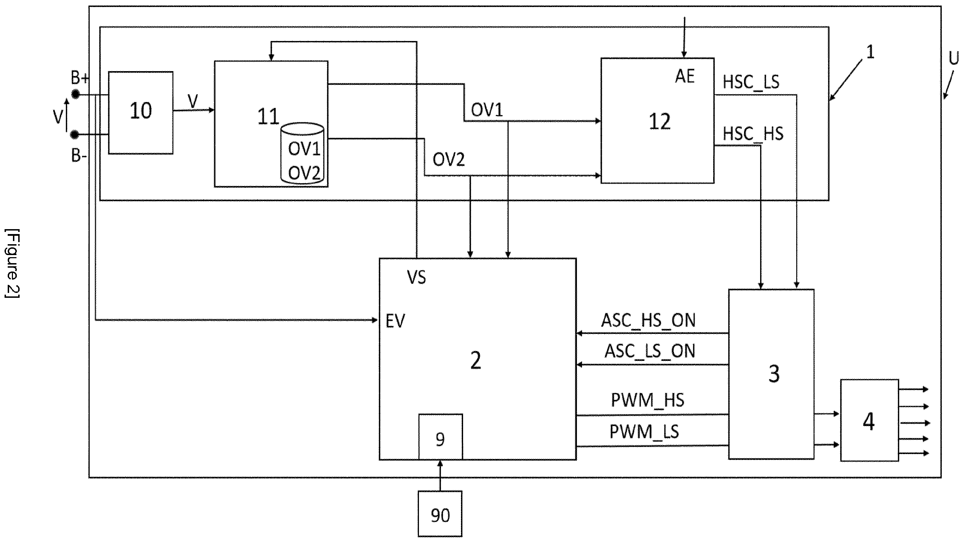

La [Fig 2] représente un schéma de principe de l'unité de commande U.

L'unité de commande U comprend un système de commande 1 comprenant un module de mesure 10 d'une tension de la source de tension continue B. Dans l'exemple décrit ici, le module de mesure 10 mesure une tension V aux bornes B+ et B-. En d'autres termes, dans l'exemple décrit ici, le module de tension 10 mesure la tension de la source de tension continue B ayant une tension nominale de 48 Volts.

Le système de commande 1 comprend en outre un module de comparaison 11 agencé pour recevoir du module de mesure 10 la tension mesurée V. Le module de comparaison 11 compare la tension V mesurée à un premier seuil de sécurité OV1. Le premier seuil de sécurité OV1 est par exemple stocké dans une mémoire permanente du module de comparaison 11.

Dans l'exemple décrit ici, le premier seuil de sécurité OV1 est compris entre 1.10 et 1.25 fois la tension nominale, par exemple 1.2 fois la tension nominale de la source de tension continue correspondant par exemple à celle du réseau de bord du véhicule. En l'occurrence, dans cet exemple, le seuil de sécurité OV1 est de 56 volts soit environ 1,17 fois la tension nominale de la source de tension continue de 48 volts.

Le module de comparaison 11 est en outre agencé pour comparer la tension V mesurée à un deuxième seuil de sécurité OV2 supérieure au premier seuil de sécurité OV1. Le deuxième seuil de sécurité OV2 est par exemple stocké dans une mémoire permanente du module de comparaison 11.

Le système de commande 1 comprend en outre un module de commande 12. Dans l'exemple décrit ici, le module de commande 12 est réalisé à partir de portes logiques. En variante, le module de commande 12 peut être un microcontrôleur.

Le module de comparaison 11 est agencé pour transmettre au module de commande 12 une information ov1 lorsque la tension mesurée V est supérieure au premier seuil de sécurité OV1. Cette information ov1 est par exemple transmise sous la forme d'un niveau logique haut lorsque la tension mesurée V est supérieure au premier seuil de sécurité OV1, et d'un niveau logique bas sinon.

Le module de comparaison 11 est également agencé pour transmettre au module de commande 12 une information ov2 lorsque la tension mesurée V est supérieure au deuxième seuil de sécurité OV2. Cette information ov2 est par exemple transmise sous la forme d'un niveau logique haut lorsque la tension mesurée V est supérieure au deuxième seuil de sécurité OV2, et d'un niveau logique bas sinon. Dans l'exemple décrit ici, le deuxième seuil de sécurité est égal à 64 volts soit 33% supérieure à la tension nominale 48V.

Sur réception de l'information ov1, le module de commande 12 émet une commande de fermeture d'un premier groupe d'interrupteurs LS, HS, choisi parmi le groupe des interrupteurs de côté haut HS c'est-à-dire le groupe haut ou le groupe des interrupteurs de côté bas LS c'est-à-dire le groupe bas.

Dans l'exemple décrit ici, le premier groupe d'interrupteurs est le groupe bas LS et la commande est une commande ASC_LS de fermeture de tous les interrupteurs du groupe bas LS.

De façon optionnelle, sur réception de l'information ov1, le module de commande 12 peut également émettre une commande d'ouverture d'un deuxième groupe d'interrupteurs LS, HS, choisi parmi le groupe des interrupteurs de côté haut HS c'est-à-dire le groupe haut ou le groupe des interrupteurs de côté bas LS c'est-à-dire le groupe bas, le deuxième groupe d'interrupteur étant différent du premier groupe. Dans ce cas, les commutations de chacun des bras X, Y et Z font l'objet d'un temps mort durant lequel les interrupteurs haut et bas du bras sont tous les deux ouverts. L'objectif est notamment que l'interrupteur dont l'ouverture est commandée soit bel et bien ouvert avant de commander la fermeture de l'autre interrupteur afin de s'assurer qu'il n'y ait pas de « cross-conduction » selon l'expression en anglais connue de l'homme du métier, signifiant que les interrupteurs haut et bas sont simultanément fermés.

Dans l'exemple décrit ici, le deuxième groupe d'interrupteurs est le groupe haut HS et le module de commande 12 peut également émettre une commande d'ouverture de tous les interrupteurs du groupe haut HS.

Sur réception de l'information ov2, le module de commande 12 émet une commande de fermeture du deuxième groupe d'interrupteurs. En l'occurrence, dans l'exemple décrit ici, les interrupteurs du deuxième groupe sont donc les interrupteurs du groupe haut HS et la commande est une commande ASC_HS de fermeture de tous les interrupteurs du groupe haut HS.

De façon optionnelle, sur réception de l'information ov2, le module de commande 12 peut également émettre une commande d'ouverture du premier groupe d'interrupteurs. En l'occurrence, dans l'exemple décrit ici, les interrupteurs du premier groupe sont donc les interrupteurs du groupe bas LS et la commande est une commande d'ouverture de tous les interrupteurs du groupe bas LS. Dans ce cas optionnel, les commutations de chacun des bras X, Y et Z font l'objet d'un temps mort.

Ainsi, dans l'exemple décrit ici, en cas d'apparition d'une surtension, le module de commande 12 transmet d'abord une commande de fermeture de tous les interrupteurs de côté bas (groupe bas LS) et éventuellement une commande d'ouverture de tous les interrupteurs de côté haut (groupe haut HS).

Sur la [Fig 1], les interrupteurs du groupe bas LS sont fermés et les interrupteurs du groupe haut HS sont ouvert. Ainsi, on peut voir sur la [Fig 1], que toutes les phases U, V, W, sont mises à un même potentiel, en l'occurrence au potentiel de la masse du véhicule B-. Ainsi, le système électrique SE est protégé si le défaut provenait d'un interrupteur côté haut défectueux resté ouvert « défaut d'état resté ouvert » ou si le défaut provenait d'un interrupteur côté bas défectueux resté fermé « défaut d'état resté fermé », ou encore si le défaut provenait d'un autre équipement sur le réseau de bord, comme par exemple une déconnexion intempestive de la première source d'alimentation continue B alors que la machine électrique tournante est en mode génératrice.

Si la tension V mesurée se stabilise sans dépasser le deuxième seuil OV2, le convertisseur est alors dans un état satisfaisant, c'est-à-dire dans un état dans lequel la surtension a été maitrisée et dans lequel le convertisseur est protégé des conséquences de la surtension. En d'autres termes, le système de commande 1 a appliqué la stratégie correcte de mise en court-circuit des bras de commutation du convertisseur de tension O eu égard au type du défaut ayant engendré la surtension.

Il est à noter que le deuxième seuil doit être paramétré pour être suffisamment éloigné du premier seuil afin de laisser le temps à la surtension de se stabiliser en dessous du deuxième seuil lorsque la mise en court-circuit des interrupteurs du premier groupe est la stratégie correcte à mettre en oeuvre par rapport au type de défaut ayant engendré la surtension.

Dans le cas contraire, si le système de commande 1 n'a pas appliqué la stratégie correcte de mise en court-circuit des bras de commutation du convertisseur de tension O, la tension V mesurée continue d'augmenter jusqu'à dépasser le deuxième seuil OV2. Lorsque le deuxième seuil OV2 est dépassé, le module de commande 12 transmet alors une deuxième commande de fermeture de tous les interrupteurs de côté haut (groupe haut HS) et éventuellement un deuxième commande d'ouverture de tous les interrupteurs de côté bas (groupe bas LS).

A ce stade, le système de commande 1 a nécessairement appliqué la stratégie correcte de mise en court-circuit des bras de commutation du convertisseur de tension O. Ainsi, la surtension est maitrisée et le convertisseur est protégé des conséquences de cette surtension.

De façon optionnelle, le module de commande 12 peut également comprendre une ou plusieurs entrées AE agencées pour recevoir des informations d'erreur, par exemple, une information d'erreur relative à une tension trop basse sur le réseau de bord (en anglais Under Voltage ou UV). Sur réception d'une information d'erreur sur la ou les entrées AE, le module de commande 12 émet également une commande de fermeture du premier groupe d'interrupteurs et éventuellement une commande d'ouverture du deuxième groupe d'interrupteurs.

Dans le mode de réalisation décrit ici, l'unité de commande U comprend en outre un module de contrôle machine 2, un module logique 3 et un contrôleur 4 plus connu sous le nom anglais « driver ».

Le module de contrôle machine 2 comprend une entrée (non représentée) pour recevoir d'une unité de commande électronique du véhicule une consigne pour soit mettre la machine électrique tournante en mode moteur selon une valeur de couple fournie, soit mettre la machine électrique tournante en mode alternateur selon un couple résistif pour recharger la source de tension continue du véhicule. Le module de contrôle machine 2 transforme cette consigne en une commande des interrupteurs de côté haut HS et de côté bas LS, ladite commande étant transmise par le biais du module logique 3 et du contrôleur 4. En d'autres termes, grâce au module de contrôle machine 2, du module logique 3 et du contrôleur 4, les interrupteurs de côté haut HS et les interrupteurs de côté bas LS reçoivent chacun une commande, par exemple par modulation de largeur d'impulsion PWM_HS, PWM_LS, d'ouverture ou de fermeture.

Le module logique 3 est conçu pour prioriser les commandes émises par le système de commande 1 par rapport aux commandes émises par le module de contrôle machine 2. Autrement dit, le système de commande 1 est prioritaire sur le module de contrôle machine 2.

Le module logique 3 reçoit donc la commande soit du module de contrôle machine 2 soit du système de commande 1 pour la fournir au contrôleur 4.

Le module logique 3 priorise donc l'envoi de la commande reçue du module de commande 12 par rapport aux commandes reçues du module de contrôle machine 2. En d'autres termes, lorsque le module logique 3 reçoit une commande du module de commande 12, il transmet celle-ci au contrôleur 4 et dans le même temps ne transmet pas au contrôleur 4 les commandes reçues du module de contrôle machine 2.

Lorsque le module de contrôle machine 2 est un microprocesseur et lorsque le module de commande 12 et le module de logique 3 sont réalisés en utilisant des portes logiques, le temps de réaction du module de contrôle machine 2 (typiquement de l'ordre de la dizaine de microsecondes) est plus long que le temps de réaction du module de commande 12 (typiquement de l'ordre de la microseconde). Ainsi, la priorisation effectuée par le module logique 3 permet d'assurer une mise en sécurité plus rapide du convertisseur de tension O et de la machine électrique tournante M.

Le module logique 3 peut en outre envoyer une information ASC_LS_ON, ASC_HS_ON, par exemple sous forme de niveau logique, au module de contrôle machine 2 pour informer ce module de contrôle machine 2 que le module de commande 12 à commander la fermeture des interrupteurs du premier groupe ou du deuxième groupe.

Dans ce mode de réalisation de l'invention, le module de contrôle machine 2 peut être en outre reliée au module de mesure 11. Ainsi, dans ce cas, le module de mesure 11 peut transmettre les informations ov1 ou ov2 au module de contrôle machine 2 qui peut ainsi :
1. vérifier que la fermeture des interrupteurs du premier groupe ou du deuxième groupe par le module de commande 12 n'est pas une erreur, et/ou
2. transmettre au module logique 3 la commande de fermeture des interrupteurs du premier groupe puis si nécessaire la commande de fermeture des interrupteurs du deuxième groupe.

Ainsi, la double transmission de la commande de fermeture des interrupteurs du premier groupe et si nécessaire du deuxième groupe permet d'avoir une redondance de commande et d'assurer un niveau de sécurité plus élevé pour le convertisseur de tension 1, en particulier dans le cas où le module de commande 12 est défaillant.

Le module de contrôle machine 2 peut en outre optionnellement comporter une entrée EV pour mesurer la tension de la source de tension qui est dans cet exemple la tension V mesuré par le module de mesure 10. Ainsi, le module de contrôle machine 2 est en mesure de vérifier le fonctionnement du module de mesure 10. En outre cela permet au module de contrôle machine 2 de pouvoir repartir dans un mode normal lorsque la tension mesurée V diminue, par exemple lorsque le module de contrôle moteur 2 reçoit en outre une information de l'unité de commande électronique du véhicule que la surtension provenait d'un autre équipement que le convertisseur de tension O.

Le module de contrôle machine 2 peut en outre optionnellement comprendre une sortie VS reliée au module de comparaison 11 pour forcer le module de comparaison 11 à indiquer au module de commande 12 que la tension mesurée est supérieure au premier seuil ou au deuxième seuil de sécurité afin de vérifier que le système de commande 1 est opérationnelle.

Le module de contrôle machine 2 peut optionnellement comprendre en outre d'autres modules de détection de défaut ou de sécurité pour détecter ou anticiper une surtension. Par exemple, le module de contrôle machine 2 peut comprendre un module de défaut de sens de courant de phase 9. Le module de défaut 9 est relié à un capteur 90 qui mesure le sens du courant de phase. En cas de mauvais sens du courant de phase, cela peut entrainer une surtension. Ainsi, lorsque le module de contrôle machine 2 reçoit une information de ce module de sécurité 9, le module de contrôle machine 2 commande directement la fermeture des interrupteurs du premier groupe et optionnellement l'ouverture des interrupteurs du deuxième groupe.

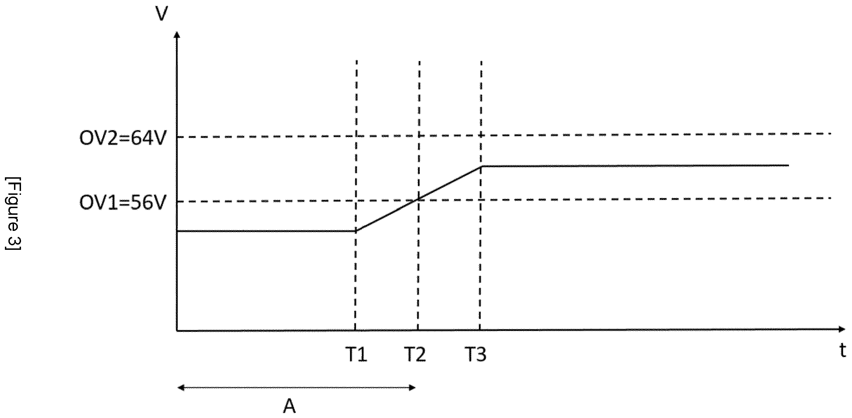

Nous allons maintenant décrire en référence à la [Fig 3] l'évolution de la tension V mesurée aux bornes B+ et B- dans le cas où une déconnexion intempestive de la première source d'alimentation continue B se produit.

Sur l'histogramme, pendant une période A dite « Normal », le convertisseur de tension O commande les interrupteurs de côté haut et de côté bas normalement en fonction de la consigne de l'unité de commande électronique du véhicule. Durant cette période A, la tension mesurée V est inférieure au premier seuil de sécurité OV1, notamment pendant une première durée elle est égale à la tension nominale de la source de tension continu, en l'occurrence 48 Volts. Pendant cette période A, à un instant T1, la première source d'alimentation continue B se déconnecte du réseau de bord alors que la machine électrique tournante est en mode génératrice. Cette déconnexion crée un phénomène de délestage de charge (en anglais « load dump ») qui occasionne une surtension sur le réseau de bord.

Suite à cette déconnexion, à un instant T2, la tension mesurée V dépasse le premier seuil de sécurité OV1 en l'occurrence de 56 Volts.

Le module de comparaison 11 du système de commande 1 envoie alors au module de commande 12 l'information ov1 selon laquelle la tension mesurée V est supérieure au premier seuil de sécurité OV1. Sur réception de cette commande, le module de commande 12 commande la fermeture des interrupteurs du premier groupe et l'ouverture des interrupteurs du deuxième groupe. En l'occurrence, dans cet exemple le module de commande 12 envoie au module logique 3 une commande ASC_LS de fermeture des interrupteurs de côté bas afin de mettre les phases à la masse et une commande d'ouverture des interrupteurs de côté haut. Le module logique 3 retransmet, quelque soient les commandes émises par ailleurs par le module de contrôle machine 2, ces commandes au contrôleur 4 pour commander la fermeture des interrupteurs du groupe bas LS, et l'ouverture des interrupteurs du groupe haut HS.

On peut voir sur l'histogramme de la [Fig 3] que la tension mesurée V continue à monter jusqu'à un instant T3 puis se stabilise à une valeur de tension comprise entre le premier seuil de sécurité OV1 et le deuxième seuil de sécurité OV2.

Cette stabilisation montre que le système de commande 1 a appliqué la stratégie correcte de mise en court-circuit des bras de commutation du convertisseur de tension O eu égard au type du défaut ayant engendré la surtension.

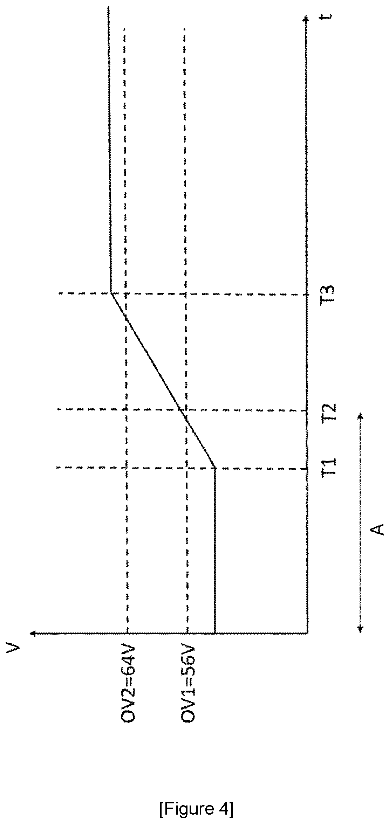

Nous allons maintenant décrire en référence à la [Fig 4] l'évolution de la tension V mesurée aux bornes B+ et B- dans le cas où un interrupteur de côté bas du convertisseur de tension O reste ouvert.

Sur l'histogramme, pendant une période A dite « Normal », le convertisseur de tension O commande les interrupteurs de côté haut et de côté bas normalement en fonction de la consigne de l'unité de commande électronique du véhicule. Durant cette période A, la tension mesurée V est inférieure au premier seuil de sécurité OV1, notamment pendant une première durée elle est égale à la tension nominale de la source de tension continu, en l'occurrence 48 Volts. Pendant cette période A, à un instant T1, l'un des interrupteurs de côté bas du convertisseur de tension O se bloque dans un état ouvert.

Suite à ce défaut apparaissant sur cet interrupteur de côté bas, à un instant T2, la tension mesurée V dépasse le premier seuil de sécurité OV1 en l'occurrence de 56 Volts.

Le module de comparaison 11 du système de commande 1 envoie alors au module de commande 12 l'information ov1 selon laquelle la tension mesurée V est supérieure au premier seuil de sécurité OV1. Sur réception de cette commande, le module de commande 12 commande la fermeture des interrupteurs du premier groupe et l'ouverture des interrupteurs du deuxième groupe. En l'occurrence, dans cet exemple le module de commande 12 envoie au module logique 3 une commande ASC_LS de fermeture des interrupteurs de côté bas afin de mettre les phases à la masse et une commande d'ouverture des interrupteurs de côté haut. Le module logique 3 retransmet, quelque soient les commandes émises par ailleurs par le module de contrôle machine 2, ces commandes au contrôleur 4 pour commander la fermeture des interrupteurs du groupe bas LS, et l'ouverture des interrupteurs du groupe haut HS.

On peut voir sur l'histogramme de la [Fig 4] que la tension mesurée V ne se stabilise pas et continue à augmenter jusqu'à atteindre puis dépasser une valeur de tension supérieure au deuxième seuil de sécurité OV2.

Cette élévation continue de la tension mesurée V montre que le système de commande 1 n'a pas appliqué la stratégie correcte de mise en court-circuit des bras de commutation du convertisseur de tension O eu égard au type du défaut engendrant la surtension.

En effet, le transistor de côté bas en défaut est resté ouvert et au moins une phase de la machine électrique tournante n'a pas été mise en court-circuit à la masse.

La tension mesurée V dépassant le deuxième seuil de sécurité OV2 en l'occurrence de 64 Volts, le module de comparaison 11 du système de commande 1 envoie alors au module de commande 12 l'information ov2 selon laquelle la tension mesurée V est supérieure au deuxième seuil de sécurité OV2. Sur réception de cette commande, le module de commande 12 commande la fermeture des interrupteurs du deuxième groupe et l'ouverture des interrupteurs du premier groupe. En l'occurrence, dans cet exemple le module de commande 12 envoie au module logique 3 une commande ASC_HS de fermeture des interrupteurs de côté haut et une commande d'ouverture des interrupteurs de côté bas. Le module logique 3 retransmet, quelque soient les commandes émises par ailleurs par le module de contrôle machine 2, ces commandes au contrôleur 4 pour commander l'ouverture des interrupteurs du groupe bas LS, et la fermeture des interrupteurs du groupe haut HS.

On peut voir sur l'histogramme de la [Fig 4] que la tension mesurée V continue à monter jusqu'à un instant T3 et se stabilise à une valeur de tension supérieure au deuxième seuil de sécurité OV2.

Cette stabilisation montre que le système de commande 1 a appliqué la stratégie correcte de mise en court-circuit des bras de commutation du convertisseur de tension O eu égard au type du défaut ayant engendré la surtension.

Le mode de réalisation précédemment décrut peut ne pas comprendre une ou plusieurs des fonctionnalités décrites précédemment comme optionnelles.

Ainsi dans le mode de réalisation précédemment décrit, les interrupteurs du premier groupe sont les interrupteurs de côté bas et les interrupteurs du deuxième groupe les interrupteurs de côte haut mais en variante, les interrupteurs du premier groupe peuvent être les interrupteurs de côté haut et les interrupteurs du deuxième groupe les interrupteurs de côte bas.

De même, la machine tournante précédemment décrite est une machine triphasée. En variante, la machine tournante électrique peut plus généralement avoir n phases, par exemple n=6 pour une machine hexaphasée. Dans ce cas, le convertisseur de tension O comporte également n bras de commutation.

De même, dans le mode de réalisation précédemment décrit, les bobines u, v, w sont montées en étoile. En variante, les bobines u, v, w peuvent être montées en triangle.

De même, dans le mode de réalisation précédemment décrit, le module logique 3, le module de commande 12 et le module de contrôle machine 2 sont réalisés sous forme d'entités distinctes. En variante, le module logique 3, le module de commande 12 et le module de contrôle machine 2 peuvent être réalisés sous la forme d'une seule entité, par exemple un microcontrôleur comportant un circuit logique programmable par exemple du type FPGA (de l'anglais « Field-Programmable Gate Array »)

En outre, dans le mode de réalisation précédemment décrit, les transistors de côté haut et de côté bas sont des MOSFETs. En variante, ces transistors peuvent être des IGBTs. 1

## Revendications

1. Système de commande (1) d'un convertisseur de tension (O), le convertisseur de tension (O) étant destiné à connecter une machine électrique tournante (M) à une source de tension continue (B), notamment à un réseau de bord, le convertisseur de tension (O) comprenant une pluralité de bras (X, Y, Z) de commutation montés en parallèle, chaque bras (X, Y, Z) comprenant un interrupteur de côté haut ( HS_X, HS_Y, HS_Z) et un interrupteur de côté bas (LS_X, LS_Y, LS_Z) connectés l'un à l'autre en un point milieu (PX, PY, PZ) destiné à être connecté à ladite machine électrique tournante, les interrupteurs de côté haut formant un groupe haut (HS) et les interrupteurs de côtés bas formant un groupe bas (LS), le système de commande (1) comprenant :
a. un module de mesure (10) de la tension (V) de la source de tension continue (B),
b. un module de comparaison (11) de la tension mesurée (V) à un premier seuil de sécurité (OV1),
c. un module de commande (12) pour générer une commande de fermeture d'un premier groupe d'interrupteurs (HS, LS) choisi parmi le groupe haut (HS) ou le groupe bas (LS), si le module de comparaison (11) indique que la tension mesurée (V) est supérieure au premier seuil de sécurité (OV1),
ledit système de commande étant **caractérisé en ce que** le module de comparaison (11) compare la tension mesurée (V) à un deuxième seuil de sécurité (OV2) supérieur au premier seuil de sécurité (OV1) et **en ce que** le module de commande (12) est en outre conçu pour, lorsque la tension mesurée (V) est supérieure ou égale au deuxième seuil de sécurité (OV2), générer une commande de fermeture d'un deuxième groupe d'interrupteur (LS, HS) choisi parmi le groupe haut (HS) ou le groupe bas (LS), ledit deuxième groupe d'interrupteurs étant différent dudit premier groupe d'interrupteur

2. Système de commande (1) selon la revendication 1, dans lequel la tension mesurée (V) est la tension entre deux bornes (B+, B-) du convertisseur de tension (O) destinées à être connectées à la source de tension continue (B).

3. Système de commande (1) selon la revendication 1 ou 2, dans lequel, lorsque la tension mesurée (V) est supérieure ou égale au premier seuil de sécurité (OV1), le module de commande (12) est en outre conçu pour générer une commande d'ouverture des interrupteurs autres que ceux du premier groupe.

4. Système de commande (1) selon l'une des revendications 1 à 3 dans lequel, le module de commande (12) est en outre conçu pour générer une commande d'ouverture du premier groupe d'interrupteur lorsque la tension mesurée (V) est supérieure ou égale au deuxième seuil de sécurité (OV2).

5. Système de commande (1) selon l'une des revendications précédentes dans lequel le premier groupe d'interrupteurs (HS, LS) est le groupe bas (LS).

6. Système électrique (SE) comprenant :
a. une première et une deuxième bornes d'alimentation (B+, B-) destinée à être reliées à une source de tension continue (B), notamment à une batterie d'un véhicule automobile,
b. une machine électrique tournante (M) comprenant un stator ayant au moins trois phases (U, V, W),
c. un convertisseur de tension (O) pour alimenter la machine électrique tournante (M) à partie de ladite source de tension continue (B), le convertisseur de tension (O) comprenant :
i. une pluralité de bras de commutation (X, Y, Z) montés en parallèle, chaque bras (X, Y, Z) comprenant un interrupteur de côté haut (HS_X, HS_Y, HS_Z) et un interrupteur de côté bas (LS_X, LS_Y, LS_Z) connectés l'un à l'autre en un point milieu (PX, PY, PZ), chaque point milieu (PX, PY, PZ) étant connecté à au moins une phase (U, V, W) de ladite machine électrique tournante (M), et
ii. une unité de commande (U) des interrupteurs de côté haut et de côté bas, ladite unité de commande (U) comprenant un système de commande (1) selon l'une des revendications précédentes.

7. Système électrique (SE) selon la revendication 6, dans lequel l'unité de commande (U) comprend en outre au moins un module de détection d'un défaut (9), par exemple un module de défaut de sens du courant de phase, et dans lequel lorsque le module de défaut (9) détecte un défaut, l'unité de commande (U) commande à la fermeture le premier groupe d'interrupteurs.

8. Système électrique (SE) selon la revendication 6 ou 7, dans lequel l'unité de commande (U) comprend en outre :
a. - un contrôleur (4) conçu pour commander les interrupteurs de côté haut et de côté bas,
b. un module de contrôle machine (2) destinée à recevoir d'une unité de commande électronique du véhicule une consigne pour soit mettre la machine électrique tournante (M) en mode moteur, soit mettre la machine électrique tournante (M) en mode alternateur, et agencée pour transformer cette consigne en une commande pour commander les interrupteurs de côté haut (HS) et de côté bas (LS) du convertisseur de tension (O),
c. un module logique (3) pour prioriser les commandes émises par le système de commande (1) par rapport aux commandes émises par le module de contrôle machine (2), le module logique (3) transmettant au contrôleur (4) la commande des interrupteurs reçue soit par le module de contrôle machine (2) soit par le système de commande (1).

9. Procédé de commande d'un système de commande d'un convertisseur de tension selon l'une des revendications 1 à 5, le convertisseur de tension (O) étant connecté à une machine électrique tournante (M) et à une source de tension continue (B), notamment à un réseau de bord, ledit procédé comprenant :
a. Une étape de mesure par le module de mesure (10) de la tension (V) de la source de tension continue (B),
b. Une étape de comparaison par le module de comparaison (11) de la tension mesurée (V) à un premier seuil de sécurité (OV1),
c. Une étape de génération par le module de commande (12) d'une commande de fermeture d'un premier groupe d'interrupteurs (LS) choisi parmi le groupe haut (HS) ou le groupe bas (LS), si la tension mesurée (V) est supérieure au premier seuil de sécurité (OV1).

## Patentansprüche

1. System zur Steuerung (1) eines Spannungswandlers (O), wobei der Spannungswandler (O) dazu bestimmt ist, eine drehende elektrische Maschine (M) an eine Gleichspannungsquelle (B) anzuschließen, insbesondere an ein Bordnetz, wobei der Spannungswandler (O) eine Mehrzahl von parallel geschaltet Schaltarmen (X, Y, Z) umfasst, wobei jeder Arm (X, Y, Z) einen Hochseiten-Schalter (HS_X, HS_Y, HS_Z) und einen Niederseiten-Schalter (LS_X, LS_Y, LS_Z) umfasst, die an einem Mittelpunkt (PX, PY, PZ) miteinander verbunden sind, der dazu bestimmt ist, an die drehende elektrische Maschine angeschlossen zu sein, wobei die Hochseiten-Schalter eine Hochgruppe (HS) und die Niederseiten-Schalter eine Niedergruppe (LS) bilden, wobei das Steuerungssystem (1) Folgendes umfasst:
a. ein Modul zur Messung (10) der Spannung (V) der Gleichspannungsquelle (B),
b. ein Modul zum Vergleich (11) der gemessenen Spannung (V) mit einer ersten Sicherheitsschwelle (OV1),
c. ein Befehlsmodul (12) zur Erzeugung eines Befehls zum Schließen einer ersten Schaltergruppe (HS, LS), die aus der Hochgruppe (HS) oder der Niedergruppe (LS) gewählt ist, wenn das Vergleichsmodul (11) angibt, dass die gemessene Spannung (V) höher als die erste Sicherheitsschwelle (OV1) ist,
wobei das Steuerungssystem **dadurch gekennzeichnet ist, dass** das Vergleichsmodul (11) die gemessene Spannung (V) mit einer zweiten Sicherheitsschwelle (OV2) vergleicht, die höher als die erste Sicherheitsschwelle (OV1) ist, und dadurch, dass das Befehlsmodul (12) ferner dafür ausgelegt ist, wenn die gemessene Spannung (V) höher als oder gleich der zweiten Sicherheitsschwelle (OV2) ist, einen Befehl zum Schließen einer zweiten Schaltergruppe (LS, HS) zu erzeugen, die aus der Hochgruppe oder der Niedergruppe gewählt ist, wobei die zweite Schaltergruppe von der ersten Schaltergruppe verschieden ist

2. Steuerungssystem (1) nach Anspruch 1, wobei die gemessene Spannung (V) die Spannung zwischen zwei Anschlüssen (B+, B-) des Spannungswandlers (O) ist, die dazu bestimmt sind, an die Gleichspannungsquelle (B) angeschlossen zu sein.

3. Steuerungssystem (1) nach Anspruch 1 oder 2, wobei, wenn die gemessene Spannung (V) höher als oder gleich der ersten Sicherheitsschwelle (OV1) ist, das Befehlsmodul (12) ferner dafür ausgelegt ist, einen Befehl zum Öffnen der anderen Schalter als jene der ersten Gruppe zu erzeugen.

4. Steuerungssystem (1) nach einem der Ansprüche 1 bis 3, wobei das Befehlsmodul (12) ferner dafür ausgelegt ist, einen Befehl zum Öffnen der ersten Schaltergruppe zu erzeugen, wenn die gemessene Spannung (V) höher als oder gleich der zweiten Sicherheitsschwelle (OV2) ist.

5. Steuerungssystem (1) nach einem der vorhergehenden Ansprüche, wobei die erste Schaltergruppe (HS, LS) die Niedergruppe (LS) ist.

6. Elektrisches System (SE) umfassend:
a. einen ersten und einen zweiten Versorgungsanschluss (B+, B-), die dazu bestimmt sind, mit einer Gleichspannungsquelle (B), insbesondere einer Batterie eines Kraftfahrzeugs verbunden zu sein,
b. eine drehende elektrische Maschine (M), die einen Stator mit wenigstens drei Phasen (U, V, W) umfasst,
c. einen Spannungswandler (O) zur Versorgung der drehenden elektrischen Maschine (M) aus der Gleichspannungsquelle (B), wobei der Spannungswandler (O) Folgendes umfasst:
i. eine Mehrzahl von parallel geschalteten Schaltarmen (X, Y, Z), wobei jeder Arm (X, Y, Z) einen Hochseiten-Schalter (HS_X, HS_Y, HS_Z) und einen Niederseiten-Schalter (LS_X, LS_Y, LS_Z) umfasst, die an einem Mittelpunkt (PX, PY, PZ) miteinander verbunden sind, wobei jeder Mittelpunkt (PX, PY, PZ) an wenigstens eine Phase (U, V, W) der drehenden elektrischen Maschine (M) angeschlossen ist, und
ii. eine Steuereinheit (U) der Hochseiten- und Niederseiten-Schalter, wobei die Steuereinheit (U) ein Steuerungssystem (1) nach einem der vorhergehenden Ansprüche umfasst.

7. Elektrisches System (SE) nach Anspruch 6, wobei die Steuereinheit (U) ferner wenigstens ein Modul zur Erkennung eines Fehlers (9) umfasst, zum Beispiel ein Modul für einen Richtungsfehler des Phasenstroms, und wobei, wenn das Fehlermodul (9) einen Fehler erkennt, die Steuereinheit (U) die erste Schaltergruppe zum Schließen steuert.

8. Elektrisches System (SE) nach Anspruch 6 oder 7, wobei die Steuereinheit (U) ferner Folgendes umfasst:
a. - eine Steuerung (4), die dafür ausgelegt ist, die Hochseiten- und Niederseiten-Schalter zu betätigen,
b. ein Maschinensteuerungsmodul (2), das dazu bestimmt ist, von einer elektronischen Steuereinheit des Fahrzeugs eine Vorgabe zu empfangen, um entweder die drehende elektrische Maschine (M) in einen Motormodus zu versetzen oder die drehende elektrische Maschine (M) in einen Wechselstromgenerator-Modus zu versetzen, und dafür angeordnet ist, diese Vorgabe in einen Befehl zur Betätigung der Hochseiten- (HS) und Niederseiten-Schalter (LS) des Spannungswandlers (O) umzuwandeln,
c. ein Logikmodul (3) zur Priorisierung der Befehle, die vom Steuerungssystem (1) ausgesendet werden, im Verhältnis zu den Befehlen, die vom Maschinensteuerungsmodul (2) ausgesendet werden, wobei das Logikmodul (3) an die Steuerung (4) den Befehl der Schalter überträgt, der entweder vom Maschinensteuerungsmodul (2) oder dem Steuerungssystem (1) empfangen wird.

9. Verfahren zur Steuerung eines Systems zur Steuerung eines Spannungswandlers nach einem der Ansprüche 1 bis 5, wobei der Spannungswandler (O) an eine drehende elektrische Maschine (M) und an eine Gleichspannungsquelle (B), insbesondere an ein Bordnetz, angeschlossen ist, wobei das Verfahren Folgendes umfasst:
a. Einen Schritt des Messens der Spannung (V) der Gleichspannungsquelle (B) durch das Messmodul (10),
b. Einen Schritt des Vergleichens der gemessenen Spannung (V) mit einer ersten Sicherheitsschwelle (OV1) durch das Vergleichsmodul (11),
c. Einen Schritt des Erzeugens, durch das Befehlsmodul (12), eines Befehls zum Schließen einer ersten Schaltergruppe (LS), die aus der Hochgruppe (HS) oder der Niedergruppe (LS) gewählt ist, wenn die gemessene Spannung (V) höher als die erste Sicherheitsschwelle (OV1) ist.

## Claims

1. System (1) for controlling a voltage converter (O), the voltage converter (O) being intended to connect a rotary electric machine (M) to a DC voltage source (B), in particular to an on-board network, the voltage converter (O) comprising a plurality of switching arms (X, Y, Z) connected in parallel, each arm (X, Y, Z) comprising a high-side switch (HS_X, HS_Y, HS_Z) and a low-side switch (LS_X, LS_Y, LS_Z) connected to one another at a midpoint (PX, PY, PZ) that is intended to be connected to said rotary electric machine, the high-side switches forming a high group (HS) and the low-side switches forming a low group (LS), the control system (1) comprising:
a. a module (10) for measuring the voltage (V) of the DC voltage source (B),
b. a module (11) for comparing the measured voltage (V) with a first safety threshold (OV1),
c. a control module (12) for generating a command to close a first group of switches (HS, LS) chosen from the high group (HS) or the low group (LS), if the comparison module (11) indicates that the measured voltage (V) is higher than the first safety threshold (OV1),
said control system being **characterized in that** the comparison module (11) compares the measured voltage (V) with a second safety threshold (OV2) higher than the first safety threshold (OV1) and **in that** the control module (12) is further designed to, when the measured voltage (V) is higher than or equal to the second safety threshold (OV2), generate a command to close a second group of switches (LS, HS) chosen from the high group (HS) or the low group (LS), said second group of switches being different from said first group of switches.

2. Control system (1) according to Claim 1, wherein the measured voltage (V) is the voltage between two terminals (B+, B-) of the voltage converter (O) that are intended to be connected to the DC voltage source (B) .

3. Control system (1) according to Claim 1 or 2, wherein, when the measured voltage (V) is higher than or equal to the first safety threshold (OV1), the control module (12) is further designed to generate a command to open the switches other than those of the first group.

4. Control system (1) according to one of Claims 1 to 3, wherein the control module (12) is further designed to generate a command to open the first group of switches when the measured voltage (V) is higher than or equal to the second safety threshold (OV2).

5. Control system (1) according to one of the preceding claims, wherein the first group of switches (HS, LS) is the low group (LS).

6. Electrical system (SE) comprising:
a. a first and a second power supply terminal (B+, B-) intended to be connected to a DC voltage source (B), in particular to a battery of a motor vehicle,
b. a rotary electric machine (M) comprising a stator having at least three phases (U, V, W),
c. a voltage converter (O) for supplying the rotary electric machine (M) with power from said DC voltage source (B), the voltage converter (O) comprising:
i. a plurality of switching arms (X, Y, Z) connected in parallel, each arm (X, Y, Z) comprising a high-side switch (HS_X, HS_Y, HS_Z) and a low-side switch (LS_X, LS_Y, LS_Z) connected to one another at a midpoint (PX, PY, PZ), each midpoint (PX, PY, PZ) being connected to at least one phase (U, V, W) of said rotary electric machine (M), and
ii. a unit (U) for controlling the high-side and low-side switches, said control unit (U) comprising a control system (1) according to one of the preceding claims.

7. Electrical system (SE) according to Claim 6, wherein the control unit (U) further comprises at least one fault detection module (9), for example a phase-current direction fault module, and wherein, when the fault module (9) detects a fault, the control unit (U) controls the first group of switches so as to close.

8. Electrical system (SE) according to Claim 6 or 7, wherein the control unit (U) further comprises:
a. a controller (4) designed to control the high-side and low-side switches,
b. a machine control module (2) intended to receive, from an electronic control unit of the vehicle, an instruction either to switch the rotary electric machine (M) to motor mode, or to switch the rotary electric machine (M) to alternator mode, and arranged to transform this instruction into a command for controlling the high-side (HS) and low-side (LS) switches of the voltage converter (O),
c. a logic module (3) for prioritizing the commands sent by the control system (1) over the commands sent by the machine control module (2), the logic module (3) transmitting, to the controller (4), the command for the switches received either by the machine control module (2) or by the control system (1) .

9. Method for controlling a system for controlling a voltage converter according to one of Claims 1 to 5, the voltage converter (O) being connected to a rotary electric machine (M) and to a DC voltage source (B), in particular to an on-board network, said method comprising:
a. a step of measuring, by means of the measurement module (10), the voltage (V) of the DC voltage source (B),
b. a step of comparing, by means of the comparison module (11), the measured voltage (V) with a first safety threshold (OV1),
c. a step of generating, by means of the control module (12), a command to close a first group of switches (LS) chosen from the high group (HS) or the low group (LS), if the measured voltage (V) is higher than the first safety threshold (OV1).
